Europäisches Patentamt

European Patent Office

Office européen des brevets

(11) Publication number: **0 406 996 A1**

# EUROPEAN PATENT APPLICATION

(21) Application number: 90301784.6

(22) Date of filing: 20.02.90

(51) Int. Cl.5: **G11C 7/00**, G11C 29/00, G06F 13/00, G06F 15/46, H03K 19/0175, H03K 19/177

(30) Priority: 21.06.89 JP 159293/89

(43) Date of publication of application:
09.01.91 Bulletin 91/02

(84) Designated Contracting States:
DE FR GB NL

(71) Applicant: KAWASAKI STEEL CORPORATION
No. 1-28, 1-Chome Kitahonmachi-Dori
Chuo-Ku, Kobe-Shi Hyogo 651(JP)

(72) Inventor: Sakamoto, Makoto
1-14-8, Minami-cho
Chiba-shi, Chiba 280(JP)

(74) Representative: Stebbing, Timothy Charles et al
Haseltine Lake & Co. Hazlitt House 28
Southampton Buildings Chancery Laneane
London WC2A 1AT(GB)

(54) Integrated circuit including programmable circuit.

(57) In an integrated circuit including therein a prog-
rammable circuit (1) and a non-volatile memory (3),
a volatile memory (2) is disposed instead of the non-
volatile memory, in the programmable circuit which
requires high voltage applied thereto upon writing,
while the non-volatile memory is disposed on the
same chip but outside the programmable circuit.
Thus, the programmable circuit is prevented from
being exposed to the high voltage in the interior
thereof by transferring as needed the program data
to the volatile memory disposed therein. Further-
more, there is provided a circuit (4) for transferring
the program data stored in the volatile memory to
said non-volatile memory, thereby making writing
rapid and easy.

FIG. 1

EP 0 406 996 A1

## INTEGRATED CIRCUIT INCLUDING PROGRAMMABLE CIRCUIT

The present invention relates to an integrated circuit including therein a programmable circuit such as a programmable logic device (PLD), etc.

There are conventionally known PLDs (programmable logic device) and the like each serving as integrated circuits (IC), with each of which a user can realize a desired circuit by his own programming. These programmable integrated circuits are in need of storing therein program data of logical specifications and circuits, etc. They therefore sometimes include in a logic circuit a circuit incorporating a non-volatile memory device such as an EPROM (erasable programmable read only memory) and an EEPROM (electric erasable programmable read only memory) Such an IC is disclosed for example in IEEE Journal of Solid-State Circuits, Vol. SC-21, No.5, October, 1986, PP776 to P773.

There is further another programmable IC which includes therein a non-volatile memory device such as a SRAM (static random access memory) for holding program data and transferring the program data from an EPROM and an EEPROM of an external memory IC upon making a power supply or at need to the non-volatile memory device.

Such prior programmable ICs each including non-volatile memory devices however suffer from lowering of the degree of integration, requiring the improvement of the same. More specifically, with a non-volatile memory device such as an EPROM integrated in the logic circuit to hold the program data, high write voltage is applied on the memory device to write the program data in the same. It is accordingly needed to separate the logic circuit and the memory device from each other in view of the circuit components being destroyed and latched up, and hence of causing the logic circuit to be lowered in the degree of integration. Accordingly, only a few examples such as a PLA (programmable logic array) can integrally be incorporated in the logic circuit as the non-volatile memory device. The difficulty described above upon the writing is not experienced by the logic device that instead includes a volatile memory device. In this situation, although the logic circuit does not suffer from the reduced degree of integration, it requires an external non-volatile memory device and also leads to the reduced degree of integration on a board which mounts an IC.

To solve such problems, Japanese Laid-Open Patent Publication No.64-78023 proposes an integrated circuit including therein a non-volatile memory device independently of a volatile memory device. The circuit can however not directly transfer program data from the outside to the volatile memory device and is in need of holding the program data in the non-volatile memory device each. In particular, the circuit is difficult to be used upon circuit evaluation such as shipping inspection and in-circuit emulation, and is costly.

In view of the above drawbacks with the prior art, it is therefore desirable to provide a handy and economical integrated circuit being capable of an improvement of the degree of integration and easing alteration of program data upon circuit evaluation such as shipping inspection and in-circuit emulation by providing therein a programmable circuit and a non-volatile memory device for storing the program data.

An integrated circuit according to the present invention comprises a volatile memory device disposed in a programmable circuit on a chip for storing program data concerning said programmable circuit, a non-volatile memory device disposed outside said programmable circuit on said chip, said non-volatile memory device permitting said program data to be written therein from the outside, and means for transferring through switching program data written in said non-volatile memory device or program data supplied from a terminal provided outside to said volatile memory device.

In addition, said means for transferring said program data includes a circuit for transferring the program data stored in said volatile memory device to said non-volatile memory device.

In the integrated circuit according to the present invention, including therein the programmable circuit and the non-volatile memory device, it has been realised that the degree of integration is lowered owing to a fact that the programmable circuit includes therein the non-volatile memory device to which high voltage must be applied upon writing. More specifically, the difficulty of the lowering of the degree of integration caused by application of high voltage to the programmable circuit is removed with more improved performance than the prior cases by disposing a volatile memory device in the programmable circuit instead of the non-volatile memory device and instead disposing the non-volatile memory device on the same chip but outside the programmable circuit, and further transferring, as required program data to the volatile memory device disposed in the programmable circuit. Accordingly, since the non-volatile memory device which causes the lowering of the degree of integration is laid out as a separate block from the programmable circuit, the degree of integration of the programmable circuit is improved together with that of the whole integrated circuit, followed by reduced capacitance among the constituent circuits to speed up the operation of the whole circuit and improve the performance of the same.

Additionally, since there is included in the integrated circuit of the present invention a transfer circuit having a function of transferring program data from the outside, the integrated circuit serves as a programmable integrated circuit of the type in which program data such as logical specifications are stored in a non-volatile manner for the purpose of its use as a fixed logic circuit upon its being actually used, and as a programmable integrated circuit of the type in which program data such as logical specifications are stored on a magnetic recording medium and the like for the purpose of its use as a variable logic circuit also upon its being actually used.

Moreover, the integrated circuit of the present invention is capable of directly transferring not only the program data written in said non-volatile memory device but also program data supplied from an external terminal to said volatile memory device. It can therefore alter the program data with ease as well as can evaluate, upon circuit evaluation such as shipping inspection and in-circuit emulation, etc., such circuits without storing program data in the non-volatile memory device each testing, making itself easy to use and economical.

Furthermore, said means for transferring said program data can include the circuit for transferring the program data stored in said volatile memory device to said non-volatile memory device. In this situation, program data of a circuit stored in the volatile memory device, evaluated and decided in circuit evaluation such as shipping inspection and in-circuit emulation, etc., can be written in the non-volatile memory device as it is in an onboard manner, thereby making the write operation rapid and easy as well as improving design and inspection efficiency.

Reference will now be made, by way of example, to the accompanying drawings in which like reference characters designate the same or similar parts throughout the figures thereof and wherein;

FIG.1 is a block diagram illustrating the construction of a first embodiment of an integrated circuit according to the present invention, and

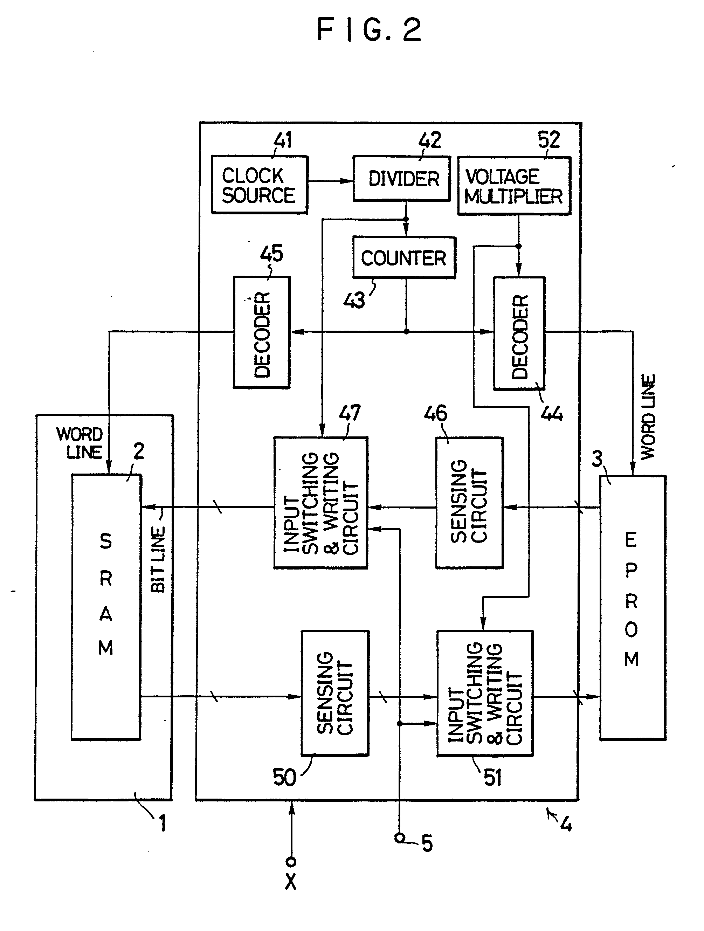

FIG.2 is a block diagram illustrating the construction of a second embodiment of the present invention.

In what follows, embodiments of integrated circuits according to the present invention will be described with reference to the accompanying drawings.

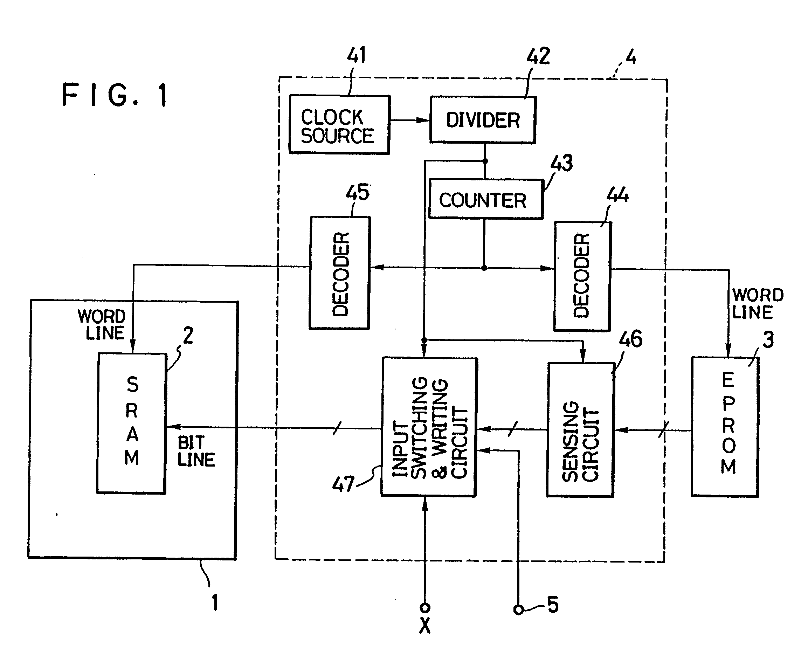

Referring to FIG.1, the construction of a first embodiment of an integrated circuit of the present invention is illustrated in the form of a block diagram . The present embodiment includes a programmable logic circuit 1, SRAMs 2 disposed in the programmable logic circuit 1 at a desired location, EPROMs 3 disposed at one place on the same chip outside the programmable logic circuit 1, and a transfer circuit 4 for transferring program data of a circuit such as logical specifications and selectors of the programmable logic circuit 1 written in the EPROM 3 at need, e.g., upon making a power supply to the SRAM in the programmable logic circuit 1. Additionally, a write circuit into the EPROM 3 is also provided.

The transfer circuit 4 includes a clock source 41, a frequency divider circuit 42 for dividing a clock generated by the clock source 41, a counter 43 for counting the clock divided as such and generating an address in synchronism with the clock, a decoder 44 for decoding the address as a read address to select a word line of the EPROM 3, a decoder 45 for decoding the address generated by the counter 43 as a write address to select a word line of the SRAM 2, a sensing circuit 46 for reading data stored in the EPROM 3 in synchronism with the clock, and an input switching/writing circuit 47 for selecting either of program data read from the sensing circuit 46 or program data inputted from an external terminal 5 exposed to the outside on the basis of an instruction of a control signal X inputted from the outside to drive a bit line of the SRAM 2.

In the above construction, the clock source 41 and the frequency divider circuit 42, etc., may be omitted, and the clock which the present integrated circuit requires may be provided externally. In addition, the sensing circuit 46 may sometimes be omitted depending upon the construction of the non-volatile memory device.

Operation of the first embodiment constructed as described above is as follows.

In the present embodiment, the EPROM 3, an example of the non-volatile memory device is disposed on the same chip as a separate block from the programmable logic circuit 1 outside the programmable logic circuit 1, to prevent high voltage from being applied to the programmable logic circuit 1 upon writing into the EPROM 3. On the contrary, the memory device for storing the program data such as logic specifications is desired to be disposed at a necessary position in the programmable logic circuit 1 from the viewpoint of a read speed and leading of wiring. For this, in the present embodiment, the SRAM 2, an example of the volatile memory device is disposed at such a position so as to prevent such a performance from being missed. Hereby, program data can be transferred from the EPROM 3 to the SRAM 2 through the transfer circuit 4 in synchronism with the same clock as needed, e.g. upon making a power supply.

Thus, in the programmable logic circuit 1, the limitation upon designing circuit arrangement that the constituent circuits must be separated because otherwise high voltage might be exerted thereon is removed and hence an increased area due to the addition of the SRAM 2 is compensated (provided), and further the degree of integration is improved beyond the influence of the increased area. Additionally, since the transfer circuit 4 is included in the integrated circuit, the program data can be transferred with ease from the outside. This is preferable for use in control of machine tools and the like wherein memory media such as a floppy disk are desired to be used in order to alter program data depending on machining conditions. Thereupon, one integrated circuit is useable for any of such applications.

Next, a second embodiment of the present invention will be described.

The second embodiment includes in the transfer circuit 4 in the same integrated circuit as the first embodiment, a sensing circuit 50, an input switching/writing circuit 51, and a voltage multiplier 52, all for transferring the program data stored in the SRAM 2 to the EPROM 3.

Other constructions are the same as the first embodiment and the description thereof will be omitted.

In the present embodiment, any program data stored in the SRAM 2 can be transferred to the EPROM 3. Therefore, in circuit evaluation such as shipping inspection and in-circuit emulation ·program data concerning a circuit which are directly stored in the SRAM 2 from the outside with use of a developing tool, etc., without use of the EPROM 3 for each testing, evaluated and decided, can be written in the EPROM 3 as it is in an onboard manner simultaneously with completion of debugging. Thus, writing operation is rapidly and easily achievable, followed by improved design and inspection efficiency.

Further, although in the above embodiments the present invention was applied to the PLD, the present invention is applicable, without limitation thereto, to integrated circuits including various types of programmable circuits such as programmable digital signal processors and the like.

Although certain preferred embodiments have been shown and described, it should be understood that many changes and modifications may be made therein without departing from the scope of the appended claims.

## Claims

1. An integrated circuit comprising:

(a) a volatile memory device (2) disposed in a programmable circuit (1) on a chip for storing program data concerning said programmable circuit;

(b) a non-volatile memory device (3) disposed externally of said programmable circuit on said chip, said non-volatile memory device permitting said program data to be written therein from the outside, and;

(c) means (4) for transferring through switching program data written in said non-volatile memory device or program data supplied from a terminal (5) provided outside to said volatile memory device.

2. An integrated circuit according to claim 1 wherein said means (4) for transferring program data comprises a clock source (41);

a frequency divider circuit (42) for dividing a clock generated by said clock source;

a counter (43) for counting said clock divided as such and generating an address in synchronism with said clock;

a decoder (44) for decoding said address as a read address to select a word line of said non-volatile memory device (3);

a decoder (45) for decoding said address issued from said counter as a write address to select a word line of said volatile memory device (2);

a sensing circuit (46) for reading the data stored in said non-volatile memory device in synchronism with said clock;

an input switching/writing circuit (47) for selecting either of the program data read by said sensing circuit or the program data inputted through an external terminal (5) presented to the outside on the basis of an instruction of a control signal (X) inputted externally to drive a bit line of said volatile memory device.

3. An integrated circuit according to claim 1 wherein said means (4) for transferring program data includes a circuit for transferring the program data stored in said volatile memory device (2) to said non-volatile memory device (3).

4. An integrated circuit according to claim 3 wherein said circuit (4) for transferring the program data stored in said volatile memory device (2) to said non-volatile memory device (3) comprises a sensing circuit (50), an input switching/writing circuit (51), and a voltage multiplier (52).

FIG. 1

WORD LINE

EPROM 3

DECODER 44

DIVIDER 42

COUNTER 43

CLOCK SOURCE 41

DECODER 45

SENSING CIRCUIT 46

INPUT SWITCHING & WRITING CIRCUIT 47

4

5

X

SRAM 2

WORD LINE

BIT LINE

1

# F I G. 2

## DOCUMENTS CONSIDERED TO BE RELEVANT

| Category | Citation of document with indication, where appropriate, of relevant passages | Relevant to claim | CLASSIFICATION OF THE APPLICATION (Int Cl⁵) |
|---|---|---|---|
| A | <u>EP - A2/A3 - 0 055 348</u><br>(IBM)<br>* Claims 1,3; fig. 1 * | 1 | G 11 C 7/00<br>G 11 C 29/00<br>G 06 F 13/00<br>G 06 F 15/46<br>H 03 K 19/0175<br>H 03 K 19/177 |
| A | <u>EP - A2/A3 - 0 238 230</u><br>(ADVANCED MICRO DEVICES)<br>* Abstract; fig. 1 * | 1,2 | |
| A | <u>EP - A2/A3 - 0 287 337</u><br>(EXEL MICROELECTRONICS)<br>* Abstract; fig. 1 * | 1,2 | |
| A | <u>EP - A2/A3 - 0 307 912</u><br>(FUJITSU LIMITED)<br>* Totality * | 1-4 | |
| A | <u>US - A - 4 761 647</u><br>(HALLENBECK et al.)<br>* Totality * | 1-4 | |
| D,A | IEEE JOURNAL OF SOLID-STATE CIRCUITS, vol. SC-21, no. 5, October 1986<br>SAU-CHING WONG et al.<br>"Novel Circuit Techniques for Zero-Power 25-ns CMOS Erasable Programmable Logic Devices (EPLD's)"<br>pages 766-773 | 1-4 | **TECHNICAL FIELDS SEARCHED (Int Cl⁵)**<br><br>G 11 C 7/00<br>G 11 C 29/00<br>G 06 F 7/00<br>G 06 F 13/00<br>G 06 F 15/00<br>H 03 K 19/00 |

The present search report has been drawn up for all claims

| Place of search | Date of completion of the search | Examiner |
|---|---|---|
| VIENNA | 28-06-1990 | BAUMANN |